# DEMANDE DE BREVET EUROPEEN

(11) **EP 4 300 582 A1**
(43) Date de publication de la demande: **03.01.2024**
(21) Numéro de dépôt: 23180054.1
(22) Date de dépôt: 19.06.2023
(51) Int. Cl.: H01L 27/15, H01L 33/00, H01L 33/14, H01L 33/18, H01L 33/20, H01L 33/24, H01L 33/02, H01L 33/08

(54) **DISPOSITIF OPTOÉLECTRONIQUE ET PROCÉDÉ DE FABRICATION D'UN TEL DISPOSITIF**

(30) Priorité: 30.06.2022 FR 2206638
(71) Demandeur: Aledia, 38130 Échirolles (FR)
(72) Inventeur: POURQUIER, Eric, 38000 Grenoble (FR); LASSIAZ, Timothée, 38000 GRENOBLE (FR)
(74) Mandataire: Germain Maureau

(57) **Abrégé**

La demande concerne une diode électroluminescente (10) pour dispositif optoélectronique (1) ou pour organe optoélectronique, la diode électroluminescente (10) comprenant un noyau semiconducteur (11) et une coque semiconductrice (13), la diode électroluminescente (10) comprenant en outre une portion implantée (30) délimitant au sein de la coque semiconductrice (13) au moins une portion passivée (33) et au moins une portion active (34), ladite au moins une portion passivée (33) ayant une conductivité strictement inférieure à une conductivité de ladite au moins une portion active (34).

La présente demande concerne également un procédé correspondant de fabrication d'un tel dispositif optoélectronique (1).

## Description

### Domaine technique de l'invention

La présente invention concerne une diode électroluminescente, ainsi qu'un dispositif optoélectronique comprenant une telle diode électroluminescente.

L'invention concerne aussi un procédé de fabrication d'un dispositif optoélectronique.

### Etat de la technique

Un dispositif optoélectronique est un dispositif configuré pour effectuer une conversion d'un signal électrique en un rayonnement électromagnétique, comme par exemple un rayonnement lumineux. Il existe dans l'état de la technique, des dispositifs optoélectroniques comprenant des diodes électroluminescentes, également connues sous l'acronyme LED pour « light-emitting diode » selon la terminologie anglo-saxonne consacrée, formées sur un substrat.

De manière générale, chaque diode électroluminescente comprend un matériau actif exploitant ou non des puits quantiques, une portion semiconductrice dopée selon un premier type de dopage, par exemple dopée P et une portion semiconductrice dopée selon un deuxième type de dopage, par exemple dopée N.

Chaque diode électroluminescente peut être formée sur la base d'éléments tridimensionnels semiconducteurs micrométriques voire nanométriques, eux-mêmes au moins partiellement obtenus par croissance par épitaxie de type dépôt en phase vapeur d'organométalliques (MOCVD) ou de type épitaxie par jets moléculaires (MBE) ou de type épitaxie en phase vapeur aux hydrures (HVPE). Les diodes électroluminescentes sont typiquement formées à base d'un matériau semiconducteur comprenant par exemple des éléments de la colonne III et de la colonne V du tableau périodique, tel qu'un composé III-V, notamment le nitrure de gallium (GaN), le nitrure d'indium et de gallium (InGaN) ou le nitrure d'aluminium et de gallium (AIGaN).

Il existe des dispositifs optoélectroniques comportant une matrice de diodes électroluminescentes présentant une certaine surface d'émission au travers de laquelle est transmis le rayonnement lumineux émis par les diodes électroluminescentes. De tels dispositifs optoélectroniques peuvent notamment être utilisés dans la constitution d'écrans d'affichage ou de systèmes de projection d'images, où la matrice de diodes électroluminescentes définit en fait une matrice de pixels lumineux où chaque pixel comporte traditionnellement au moins un sous-pixel pour générer chaque couleur, chaque sous-pixel contenant lui-même au moins une diode électroluminescente.

Une des difficultés liée à l'augmentation de la définition des écrans est de parvenir à ce que le rayonnement lumineux émis par les diodes électroluminescentes tridimensionnelles d'un sous-pixel ne se mélange pas avec le rayonnement lumineux émis par les diodes électroluminescentes d'un sous-pixel adjacent afin d'améliorer les contrastes. Or, cette problématique s'avère de plus en plus difficile à résoudre compte tenu de la miniaturisation croissante des diodes électroluminescentes.

Par ailleurs, lorsque la définition des écrans augmente, les dimensions entre les diodes électroluminescentes et les dimensions de chaque sous-pixel deviennent micrométriques, voire nanométriques. L'emploi de diodes électroluminescentes tridimensionnelles devient alors inéluctable avec des dimensions de diodes électroluminescentes tridimensionnelles toujours plus petites. Or, l'intensité lumineuse émise par les diodes électroluminescentes tridimensionnelles nanométriques décroît drastiquement à mesure que la taille des diodes électroluminescentes tridimensionnelles se réduit.

Cette difficulté peut notamment être causée par la présence de défauts cristallins, générés lors de la fabrication de la diode électroluminescente. Il est d'ailleurs fréquent de constater ces défauts cristallins à la base de la diode électroluminescente en particulier pour des diodes électroluminescentes ayant une forme de fil ou de pyramide. Ces défauts cristallins peuvent générer des dislocations dans la structure cristalline qui conduisent à terme, à la dégradation des puits quantiques existants. Il en ressort des recombinaisons non-radiatives non désirées, entraînant ainsi une chute de l'efficacité lumineuse et du rendement global. En effet, il a été constaté que la présence de dégradations au niveau de la base d'une diode électroluminescente ayant une forme de fil ou de pyramide affectait l'efficacité quantique interne (IQE) de cette diode électroluminescente.

### Objet de l'invention

La présente invention a pour but de proposer une solution qui réponde à tout ou partie des problèmes précités. En particulier, la présente invention a pour but d'améliorer le rendement d'injection, et le rendement quantique interne des diodes électrolu m inescentes.

Ce but peut être atteint grâce à la mise en oeuvre d'une diode électroluminescente pour dispositif optoélectronique, la diode électroluminescente présentant une forme tridimensionnelle et comprenant une hauteur s'étendant selon une première direction entre une partie proximale et une partie distale opposée à ladite partie proximale le long de ladite première direction, ladite diode électroluminescente comprenant :
- un noyau semiconducteur dopé selon un premiertype de conductivité, la partie proximale correspondant à une base de croissance dudit noyau semiconducteur ;
- une coque semiconductrice dopée selon un deuxième type de conductivité opposé au premier type de conductivité, ladite coque semiconductrice recouvrant au moins partiellement ledit noyau semiconducteur ;
la diode électroluminescente comprenant une portion implantée s'étendant sur une hauteur implantée comptée suivant la première direction, ladite hauteur implantée étant strictement inférieure à la hauteur de la diode, ladite portion implantée étant disposée entre la partie distale et la partie proximale et étant disjointe de la partie distale, de sorte que la portion implantée délimite au sein de la coque semiconductrice au moins une portion passivée disjointe de la partie distale de la diode électroluminescente, la coque semiconductrice comprenant au moins une portion active délimitée au moins partiellement par ladite au moins une portion passivée, ladite au moins une portion passivée ayant une conductivité strictement inférieure à une conductivité de ladite au moins une portion active.

Les dispositions précédemment décrites permettent de proposer une diode électroluminescente comprenant une portion implantée ayant une conductivité diminuée localement. La forme tridimensionnelle de la diode électroluminescente permet en outre de définir plus simplement une portion implantée dans laquelle la conductivité est diminuée.

La diode électroluminescente peut en outre présenter une ou plusieurs des caractéristiques suivantes, prises seules ou en combinaison.

De manière générale, la partie proximale correspond à la partie de la diode électroluminescente dirigée vers le substrat de croissance à partir duquel les portions de la diode électroluminescente ont crû. Par exemple, la partie proximale peut correspondre à la base de croissance du noyau semiconducteur. Cette partie proximale comporte typiquement une proportion de défaut cristallin plus importante que la partie distale.

De manière générale, la coque semiconductrice comprend la partie distale.

Plus précisément, la partie distale peut correspondre à une extrémité de la coque semiconductrice disposé d'un côté opposé à celui de la coque semiconductrice qui est dirigé vers le noyau semiconducteur.

Selon un mode de réalisation, la partie distale est l'extrémité de la coque semiconductrice opposée à la partie proximale du noyau semiconducteur.

Selon un mode de réalisation, la partie distale est la portion la plus éloignée possible de la base de croissance dudit noyau semiconducteur.

Selon un mode de réalisation, la coque semiconductrice recouvre le noyau semiconducteur du côté de la partie distale, et ne recouvre pas le noyau semiconducteur du côté de la partie proximale.

Selon un mode de réalisation, la portion implantée délimite au sein du noyau semiconducteur au moins une première portion implantée disjointe de la partie distale de la diode électroluminescente, le noyau semiconducteur comprenant au moins une première portion non-implantée délimitée au moins partiellement par ladite au moins une première portion implantée, ladite au moins une première portion implantée ayant une concentration ionique strictement différente d'une concentration ionique de ladite au moins une première portion non-implantée.

Selon un mode de réalisation, la hauteur implantée de la portion implantée, comptée le long de la première direction, est inférieure à 500 nm.

Selon un mode de réalisation, le noyau semiconducteur comprend du nitrure de gallium dopé N.

Selon un mode de réalisation, la coque semiconductrice comprend du nitrure de gallium dopé P.

Par « dopage P » ou « dopé P », on entend qu'un matériau semiconducteur comprend une forte quantité d'atomes accepteurs d'électrons permettant d'obtenir une plus faible densité d'électrons libres, donc un excès de trous, lesdits trous étant positivement chargés.

Par « dopage N » ou « dopé N », on entend qu'un matériau semiconducteur comprend une forte quantité d'atomes donneurs d'électrons afin d'obtenir une plus forte densité d'électrons libres, qui sont négativement chargés.

Par exemple un atome donneur d'électrons peut être : le silicium ou le germanium.

Par exemple un atome accepteur d'électron peut être : le magnésium.

Selon un mode de réalisation, la portion implantée correspond à un volume de la diode électroluminescente délimité par deux plans distincts, et parallèles entre eux, par exemple par rapport à une face de support du dispositif optoélectronique. Selon un mode de réalisation, lesdits deux plans distincts correspondent à une section de coupe de la diode électroluminescente perpendiculairement à la première direction.

Selon un mode de réalisation, la portion implantée est une zone de la diode électroluminescente s'étendant transversalement à la première direction, et dans laquelle des ions sont implantés, où chaque ion implanté forme :
- un complexe avec un élément dopant, le dopage selon le deuxième type de conductivité de la coque semiconductrice étant neutralisé au niveau de la portion passivée ; ou
- des niveaux profonds ce qui limite ou supprime la mobilité des porteurs de charge positive ou négative, sans que ces niveaux profonds ne servent de centres de recombinaison non radiatifs.

Selon un mode de réalisation, chaque ion implanté dans la portion implantée forme un complexe avec un élément dopant, de sorte que le dopage selon le premier type de conductivité du noyau semiconducteur soit neutralisé au niveau de la première portion implantée.

Selon un mode de réalisation, l'implantation ionique comprend l'implantation d'au moins un ion choisi parmi les ions argon, les ions hélium, les ions néon, les ions oxygène, les ions germanium, les ions arsenic, les ions phosphore, les ions bore, les ions magnésium, les ions silicium, les ions aluminium, les ions fluor, les ions azote, et les ions hydrogène.

Ainsi, il est possible d'implanter des ions dans des niveaux profonds, de manière à neutraliser les porteurs de charges libre du noyau semiconducteur et/ou de la coque semiconductrice au niveau de la première portion implantée et/ou de la portion passivée.

Selon un mode de réalisation, les ions implantés sont des ions hydrogène.

Selon un mode de réalisation dans lequel le noyau semiconducteur est constitué principalement de nitrure de gallium dopé par le magnésium, les ions hydrogène implantés forment avec le dopant magnésium, un complexe magnésium hydrogène Mg-H. Ainsi, l'implantation ionique permet de neutraliser le dopage P en magnésium, et permet ainsi de passiver la première portion implantée, afin de diminuer sa conductivité.

Par « composé constitué principalement d'un matériau », on entend qu'un composé comprend une proportion supérieure ou égale à 95% dudit matériau, cette proportion étant préférentiellement supérieure à 99%.

Selon un mode de réalisation, au moins un élément semiconducteur choisi dans le groupe comprenant le noyau semiconducteur et la coque semiconductrice présente une forme filaire, conique, tronconique, de pyramide, ou de pyramide tronquée.

Il est donc bien compris que la forme tridimensionnelle de la diode électroluminescente dépend de la forme du noyau semiconducteur et de la forme de la coque semiconductrice.

Selon un mode de réalisation, la diode électroluminescente a une forme tridimensionnelle de microfil, de nanofil, de cône, de tronc de cône, ou de pyramide.

Selon un mode de réalisation, la portion implantée est positionnée, suivant la première direction, de sorte à incorporer la partie proximale de la diode électroluminescente.

Selon un mode de réalisation, la portion implantée est disjointe de la partie proximale.

Le but de l'invention peut également être atteint grâce à la mise en oeuvre d'un organe optoélectronique comprenant un support s'étendant selon un plan, et au moins une diode électroluminescente du type d'une de celles décrites précédemment ; la portion implantée de ladite au moins une diode électroluminescente étant sensiblement parallèle au plan du support.

Selon un mode de réalisation, la première direction est perpendiculaire au plan du support.

De manière avantageuse, l'organe optoélectronique peut comprendre une couche de remplissage intercalaire (par exemple la couche de planarisation) disposée entre deux diodes électroluminescentes. Ladite couche de remplissage intercalaire peut présenter un profil de réaction à l'implantation ionique approprié, régissant la profondeur d'implantation en fonction de l'énergie d'implantation, typiquement similaire à celui des matériaux composant la diode électroluminescente, et ainsi comprendre une portion intercalaire implantée parallèlement au plan du support et dans le prolongement de la portion implanté des diodes électroluminescentes. De cette manière, il est possible de déterminer et de contrôler la profondeur d'implantation ionique en fonction de l'énergie d'implantation. Ainsi, il est possible de maîtriser l'implantation ionique lorsqu'elle est mise en oeuvre sur une portion transversale continue de l'organe optoélectronique. Les dispositions précédemment décrites s'appliquent également au dispositif optoélectronique objet de l'invention.

En effet, le but de l'invention peut également être atteint grâce à la mise en oeuvre d'un dispositif optoélectronique comprenant :
- un support présentant une face de support ;
- au moins une diode électroluminescente du type d'une de celles décrites précédemment, coopérant directement ou indirectement avec ladite face de support ;
- un premier élément conducteur connecté électriquement au noyau semiconducteur de la diode électroluminescente, et
- un deuxième élément conducteur connecté électriquement à la coque semiconductrice de la diode électroluminescente.

Les dispositions précédemment décrites permettent de proposer un dispositif optoélectronique à diodes électroluminescentes adapté pour effectuer la conversion d'un signal électrique en un rayonnement lumineux.

Le dispositif optoélectronique peut en outre présenter une ou plusieurs des caractéristiques suivantes, prises seules ou en combinaison.

Selon un mode de réalisation, ladite au moins une diode électroluminescente est disposée sur la face de support de sorte que la partie proximale de ladite au moins une diode électroluminescente soit tournée vers la face de support du support, et de sorte que la première direction s'étende transversalement à la face de support.

Selon un mode de réalisation, le noyau semiconducteur est disposé sur la face de support de manière à être en contact avec le support par la partie proximale.

Selon un mode de réalisation, la coque semiconductrice recouvre intégralement le noyau semiconducteur lorsqu'il est en contact avec la face de support du support.

Selon un mode de réalisation, le support est solidaire d'une base assurant un maintien mécanique général du dispositif optoélectronique.

Enfin, le but de l'invention peut être atteint grâce à la mise en oeuvre d'un procédé de fabrication d'un dispositif optoélectronique comprenant les étapes suivantes :
- une étape de fourniture d'un dispositif optoélectronique initial comprenant :
   ∘ un support présentant une face de support ; et
   ∘ au moins une diode électroluminescente coopérant directement ou indirectement avec ladite face de support, ladite au moins une diode électroluminescente présentant une forme tridimensionnelle, et comprenant une hauteur s'étendant selon une première direction entre une partie proximale et une partie distale opposée à ladite partie proximale le long de ladite première direction, ladite diode électroluminescente comprenant un noyau semiconducteur dopé selon un premier type de conductivité, la partie proximale correspondant à une base de croissance dudit noyau semiconducteur, et une coque semiconductrice dopée selon un deuxième type de conductivité opposé au premier type de conductivité, ladite coque semiconductrice recouvrant au moins partiellement ledit noyau semiconducteur;
- une étape de passivation de l'au moins une diode électroluminescente pour former le dispositif optoélectronique, dans laquelle l'au moins une diode électroluminescente est passivée sur une portion implantée s'étendant sur une hauteur implantée comptée suivant la première direction, ladite hauteur implantée étant strictement inférieure à la hauteur de la diode électroluminescente, ladite portion implantée étant disposée entre la partie distale et la partie proximale, et étant disjointe de la partie distale, de sorte que la portion implantée délimite au sein de la coque semiconductrice au moins une portion passivée disjointe de la partie distale de la diode électroluminescente, la coque semiconductrice comprenant au moins une portion active délimitée au moins partiellement par ladite au moins une portion passivée, ladite au moins une portion passivée ayant une conductivité strictement inférieure à une conductivité de ladite au moins une portion active.

Les dispositions précédemment décrites permettent de fabriquer un dispositif optoélectronique comprenant au moins une diode électroluminescente comprenant une portion implantée ayant une conductivité diminuée localement. La forme tridimensionnelle de la diode électroluminescente permet délimiter une portion implantée dans laquelle la conductivité est diminuée, lors de l'étape de passivation.

Par portion, ou élément « passivé » ou « neutralisé », on entend que ladite portion ou ledit élément voit la valeur absolue de sa conductivité diminuer. Par exemple, ladite portion ou ledit élément peut devenir isolant après avoir subi l'étape de passivation.

Le procédé de fabrication peut en outre présenter une ou plusieurs des caractéristiques suivantes, prises seules ou en combinaison.

Selon un mode de réalisation, lors de l'étape de passivation, l'au moins une diode électroluminescente est passivée de sorte que la portion implantée délimite également au sein du noyau semiconducteur au moins une première portion implantée disjointe de la partie distale de la diode électroluminescente, le noyau semiconducteur comprenant au moins une première portion non-implantée délimitée au moins partiellement par ladite au moins une première portion implantée, ladite au moins une première portion implantée ayant une concentration ionique strictement différente d'une concentration ionique de ladite au moins une première portion non-implantée.

Selon un mode de réalisation, lors de l'étape de fourniture d'un dispositif optoélectronique initial, ledit dispositif optoélectronique initial comprend un premier élément conducteur connecté électriquement au noyau semiconducteur de la diode électroluminescente, et un deuxième élément conducteur connecté électriquement à la coque semiconductrice de la diode électroluminescente.

Selon un mode de réalisation, lors de l'étape de fourniture d'un dispositif optoélectronique initial, ladite au moins une diode électroluminescente est disposée sur la face de support du support de sorte que la partie proximale de l'au moins une diode électroluminescente soit tournée vers la face de support du support, et de sorte que la première direction s'étende transversalement à ladite face de support.

Selon un mode de réalisation, l'au moins une diode électroluminescente présentant une forme tridimensionnelle peut être fabriquée conformément à l'un des modes de réalisation décrits dans les documents FR3031242A1, ou FR3098013A1.

Selon un mode de réalisation, l'étape de passivation est mise en oeuvre par une implantation ionique, d'une manière permettant de neutraliser le dopage selon le deuxième type de conductivité de la coque semiconductrice au niveau de la portion passivée.

Ainsi, et de manière avantageuse, il est possible de modifier la conductivité de la première portion implantée au niveau de la portion passivée par une implantation ionique.

Selon un mode de réalisation, l'implantation ionique est réalisée par l'implantation d'ions à travers la diode électroluminescente, et/ou à travers le dispositif optoélectronique.

Selon un mode de réalisation, l'étape de passivation comprend l'implantation d'au moins un ion choisi parmi les ions argon, les ions hélium, les ions néon, les ions oxygène, les ions germanium, les ions arsenic, les ions phosphore, les ions bore, les ions magnésium, les ions silicium, les ions aluminium, les ions fluor, les ions azote, et les ions hydrogène.

Ainsi, il est possible d'implanter des ions dans des niveaux profonds, de manière à neutraliser les porteurs de charges libre du noyau semiconducteur et/ou de la coque semiconductrice au niveau de la première portion implantée et de la portion passivée.

De manière synergique, la neutralisation des porteurs de charge libre lors de l'étape de passivation permet de rendre le noyau semiconducteur et la coque semiconductrice moins conducteurs sans créer de centres de recombinaison des porteurs non radiatifs, ce qui serait dommageable dans le cas de dispositifs optoélectroniques.

Avantageusement, l'étape de passivation par implantation ionique d'une diode électroluminescente tridimensionnelle permet d'implanter simultanément des ions dans le noyau semiconducteur et dans la coque semiconductrice.

Ainsi, l'étape de passivation est mise en oeuvre par implantation ionique en volume. Il est ainsi possible d'implanter simultanément la coque semiconductrice et le noyau semiconducteur, en ne passivant électriquement uniquement l'élément semiconducteur (parmi la coque semiconductrice et le noyau semiconducteur) qui a un type de conductivité de type p. Cela permet d'effectuer une désactivation différentielle des porteurs de charge entre la partie semiconductrice dopée P, et la partie semiconductrice dopée N.

Selon un mode de réalisation, une dose d'ions implantée est comprise entre 10¹¹ at/cm², et 10¹⁴ at/cm². Par exemple, ladite dose d'ions implantée peut être définie en fonction de la masse de l'ion implanté, et en fonction de l'épaisseur de matériau à traverser.

Selon un mode de réalisation, l'étape de passivation est mise en oeuvre sur une hauteur implantée, comptée le long de la première direction, inférieure à 500 nm. Ainsi, il est possible de former la portion implantée, par exemple par implantation ionique, en utilisant des gammes d'énergie d'implantation habituellement utilisées dans les procédés microélectroniques.

Selon un mode de réalisation, une énergie d'implantation est comprise entre 1 keV, et 500 keV. Par exemple, ladite énergie d'implantation peut être définie en fonction de la masse de l'ion implanté, et en fonction de l'épaisseur de matériau à traverser.

Selon un mode de réalisation, l'étape de passivation est mise en oeuvre par une implantation d'ions hydrogène.

De manière avantageuse, une implantation hydrogène, c'est-à-dire une implantation d'ions H+, permet de passiver plus efficacement un matériau dopé P qu'un matériau dopé N, en utilisant des faibles doses d'implantation ionique.

De cette manière, il est possible de passiver sélectivement ou de manière différentielle, un matériau dopé P par rapport à un matériau dopé N en une seule étape de procédé.

Selon un mode de réalisation l'étape de passivation est mise en oeuvre par implantation ionique à partir de la partie proximale vers la partie distale.

Selon un mode de réalisation l'étape de passivation est mise en oeuvre par implantation ionique à partir de la partie distale vers la partie proximale.

Selon un mode de réalisation, l'implantation ionique est mise en oeuvre à partir d'une face arrière du support, ladite face arrière du substrat étant opposée à la face de support du support.

Selon un mode de réalisation, l'implantation ionique est mise en oeuvre à partir de la face de support.

Selon un mode de réalisation, l'étape de passivation est mise en oeuvre au niveau de la partie proximale, de manière à ce que la partie proximale soit incluse dans la portion implantée.

Ainsi, et de manière avantageuse, il est possible de neutraliser la conductivité au niveau de la partie proximale. Par exemple dans le cas d'une diode électroluminescente tridimensionnelle en forme de microfil, de nanofil, de cône, de tronc de cône ou de pyramide, il est possible de neutraliser la partie proximale, afin d'émettre de la lumière qu'au niveau de la partie distale.

Ainsi, tout défaut cristallin possiblement présent au niveau de la partie proximale sera neutralisé. Il est alors possible d'améliorer l'efficacité d'émission et l'extraction de lumière de la diode électroluminescente tridimensionnelle.

Selon un mode de réalisation, le premier élément conducteur est connecté électriquement au noyau semiconducteur au niveau de la partie proximale, par exemple par l'intermédiaire d'ouvertures traversantes ménagées à travers le support. Ainsi, dans le cas où le noyau semiconducteur est dopé N, et dans le cas où l'étape de passivation a un faible impact sur la conductivité du noyau semiconducteur, il est possible garantir une bonne connexion électrique entre le noyau semiconducteur et le premier élément conducteur, tout en passivant la portion passivée.

Selon un mode de réalisation, l'étape de passivation est mise en oeuvre de manière à ce que la portion implantée soit disjointe de la partie proximale.

Les dispositions précédemment décrites permettent de proposer une diode électroluminescente ayant au moins deux premières portions actives et au moins deux portions actives séparées par la portion implantée. Chaque première portion non-implantée adjacente à une portion active sera alors apte à émettre de la lumière, par conversion d'énergie électrique en rayonnement lumineux.

Selon un mode de réalisation, le procédé de fabrication comprend en outre une étape de planarisation dans laquelle une couche de planarisation est déposée au niveau de la face de support du support jusqu'à ce qu'une épaisseur de la couche de planarisation, vue selon la première direction et comptée à partir de la face de support, soit au moins égale à la hauteur de l'au moins une diode électroluminescente.

Selon un mode de réalisation, la couche de planarisation comprend un matériau isolant, par exemple le dioxyde de silicium SiO₂.

Selon un mode de réalisation, l'étape de planarisation est mise en oeuvre de manière à recouvrir l'au moins une diode électroluminescente.

Selon un mode de réalisation, l'étape de planarisation est mise en oeuvre avant l'étape de passivation.

De cette manière, l'étape de planarisation permet d'uniformiser une épaisseur du dispositif optoélectronique le long de la première direction de manière à contrôler les profondeurs d'implantation lors de l'étape de passivation.

Selon un mode de réalisation, le procédé de fabrication comprend en outre une étape de recuit dans laquelle le dispositif optoélectronique est chauffé à une température de recuit, ladite température de recuit étant inférieure à 500°C, et notamment comprise entre 400°C et 500°C.

De manière avantageuse, l'étape de recuit permet de régénérer l'élément semiconducteur dopé N, comme par exemple le noyau semiconducteur, afin de limiter l'impact de l'étape de passivation sur cet élément semiconducteur. Cela permet en outre d'obtenir une passivation différentielle entre l'élément semiconducteur dopé N, et l'élément semiconducteur dopé P.

Selon un mode de réalisation, la portion implantée correspond à la coque semiconductrice uniquement, par la face avant, ou par la face arrière, le noyau semiconducteur étant masqué localement par une résine, empêchant ainsi l'implantation du noyau semiconducteur.

### Description sommaire des dessins

D'autres aspects, buts, avantages et caractéristiques de l'invention apparaîtront mieux à la lecture de la description détaillée suivante de modes de réalisation préférés de celle-ci, donnée à titre d'exemple non limitatif, et faite en référence aux dessins annexés sur lesquels :
La figure 1 est une vue schématique d'un dispositif optoélectronique selon un mode de réalisation particulier de l'invention.
La figure 2 est une vue schématique d'un dispositif optoélectronique selon un mode de réalisation particulier de l'invention.
La figure 3 est une vue schématique de certaines étapes du procédé de fabrication selon un mode de réalisation particulier de l'invention.
La figure 4 est une vue schématique de certaines étapes du procédé de fabrication selon un mode de réalisation particulier de l'invention.
La figure 5 est une vue schématique de certaines étapes du procédé de fabrication selon un mode de réalisation particulier de l'invention.
La figure 6 est une vue schématique de l'étape de passivation selon un mode de réalisation particulier de l'invention.
La figure 7 est une vue schématique de l'étape de passivation selon un mode de réalisation particulier de l'invention.
La figure 8 est une vue schématique de l'étape de passivation selon un mode de réalisation particulier de l'invention.

### Description détaillée

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux.

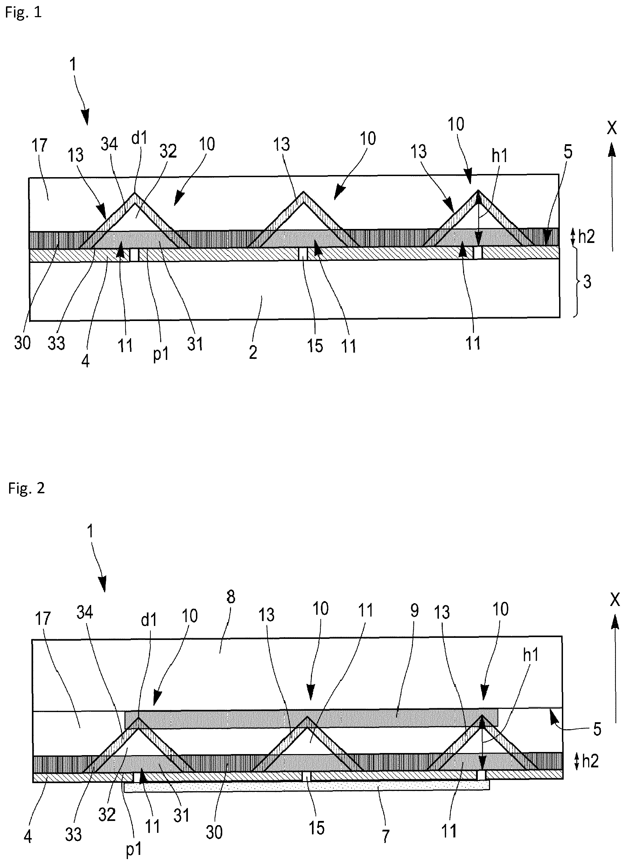

Comme cela est illustré sur les figures 1 à 8, l'invention concerne une diode électroluminescente 10, un organe optoélectronique, et un dispositif optoélectronique 1 comprenant au moins une telle diode électroluminescente 10.

Le dispositif optoélectronique 1 comprend un support 3, 8 comportant généralement un empilement d'une couche monolithique (non représentée), d'une couche d'électrode inférieure 2 qui peut être une couche de germination conductrice, et d'une première couche d'isolation électrique 4. La couche monolithique peut être formée dans un matériau semiconducteur dopé ou non, par exemple du silicium ou encore du germanium, et plus particulièrement du silicium monocristallin. Il peut aussi être formé en alumine cristallisée voire en un matériau semiconducteur III-V, par exemple en GaN. Il peut alternativement s'agir d'un substrat de type silicium sur isolant ou « SOI » pour « Silicon On Insulator » selon la terminologie anglo-saxonne consacrée. Alternativement, la couche monolithique peut être formée dans un matériau électriquement isolant. La couche d'électrode inférieure 2 sert à former une ou plusieurs premières électrodes inférieures et peut servir de couche de germination pour la croissance de portions de diodes électroluminescentes 10. Dans la suite de la description, il est fait référence à une partie proximale p1 de la diode électroluminescente. Cette partie proximale p1 correspond à la partie de la diode électroluminescente 10 qui dirigée vers le substrat de croissance (ou par exemple la couche d'électrode inférieure 2) à partir duquel les portions de la diode électroluminescente 10 ont crû. Cette couche d'électrode inférieure 2 peut être continue ou discontinue. Le matériau composant la couche d'électrode inférieure 2 peut être un nitrure, un carbure ou un borure d'un métal de transition de la colonne IV, V ou VI du tableau périodique des éléments ou une combinaison de ces composés. En pratique dans la suite du procédé de fabrication, cette couche d'électrode inférieure 2 de germination peut être complétée ou remplacée par des métaux comme l'aluminium ou le cuivre. La première couche d'isolation électrique 4 peut comprendre une couche électriquement isolante qui recouvre la couche d'électrode inférieure 2. Outre ses propriétés d'isolation électrique, elle forme un masque de croissance autorisant la croissance, par exemple épitaxiale, de parties dopées des diodes électroluminescentes 10 à partir d'ouvertures traversantes 15 délimitées par ce masque de croissance débouchant localement sur la couche d'électrode inférieure 2. Selon une variante non limitative, il peut être prévu que le support 3, 8 comprenne une base 8 assurant un maintien mécanique général du dispositif optoélectronique 1. Par exemple, cette base 8 peut être rapportée au niveau de la partie distale d1 des diodes électroluminescentes 10 et former le support 3, 8. Dans ce cas, le substrat ayant servi pour la croissance des parties dopées (comme par exemple le noyau semiconducteur 11, et la coque semiconductrice 13 qui seront présentées plus loin) peut être supprimé. Ainsi, la partie proximale p1 correspond à la partie de la diode électroluminescente 10 la plus éloignée de la base 8 formant le support 3, 8 ; et la partie distale d1 est la plus proche de la base 8 formant le support 3, 8.

Le support 3, 8 du dispositif optoélectronique 1 selon l'invention présente une face de support 5 qui coopère directement ou indirectement avec au moins une diode électroluminescente 10 selon l'invention. Par exemple, comme cela est illustré sur la figure 1 les diodes électroluminescentes 10 peuvent être disposées sur la face de support 5 du support 3, 8, elle coopèrent donc directement avec la face de support 5 du support 3, 8. Alternativement et comme représenté sur la figure 2, c'est la base 8 qui forme le support 3, 8. Dans ce cas, la face de support 5 est dirigée vers la partie distale d1 des diodes électroluminescentes, et coopère avec celles-ci indirectement, par exemple par l'intermédiaire d'une couche de planarisation 17 qui sera décrite plus loin. Chaque diode électroluminescent 10 présente une forme tridimensionnelle et comprend une hauteur h1 s'étendant selon une première direction notée « X » entre la partie proximale p1 (définie plus haut) et une partie distale d1 opposée à ladite partie proximale p1 le long de ladite première direction X. Comme indiqué précédemment, la partie proximale p1 correspond à la partie de la diode électroluminescente 10 dirigée vers le substrat de croissance à partir duquel les portions de la diode électroluminescente 10 ont crû.

Selon un mode de réalisation, la diode électroluminescente 10 est disposée sur la face de support 5 de sorte que la partie proximale p1 de ladite au moins une diode électroluminescente 10 soit tournée vers la face de support 5 du support 3, 8. De manière générale, les diodes électroluminescentes 10 sont disposées de sorte que la première direction X s'étende transversalement à la face de support 5, par exemple perpendiculairement. La diode électroluminescente 10 comprend un noyau semiconducteur 11 dopé selon un premier type de conductivité, et une coque semiconductrice 13 dopée selon un deuxième type de conductivité opposé au premier type de conductivité, la coque semiconductrice 13 recouvrant au moins partiellement le noyau semiconducteur 11. Il peut notamment être prévu que la coque semiconductrice 13 recouvre le noyau semiconducteur 11 du côté de la partie distale d1, et ne recouvre pas le noyau semiconducteur 11 du côté de la partie proximale p1 Comme cela est indiqué sur les figures, la partie proximale p1 peut par exemple correspondre à la base de croissance du noyau semiconducteur 11. De manière générale, la coque semiconductrice 13 comprend la partie distale d1. Plus précisément, la partie distale d1 peut correspondre à une extrémité de la coque semiconductrice 13 disposé d'un côté opposé à celui de la coque semiconductrice 13 qui est dirigé vers le noyau semiconducteur 11.

Le dispositif optoélectronique 1 comprend en outre un premier élément conducteur 7 connecté électriquement au noyau semiconducteur 11 de la diode électroluminescente 10, et un deuxième élément conducteur 9 connecté électriquement à la coque semiconductrice 13 de la diode électroluminescente 10. Comme on peut le voir sur le mode de réalisation non limitatif représenté sur la figure 2, le deuxième élément conducteur 9 est disposé au niveau de la face de support 5 du support 3, 8, de manière à être connecté électriquement à la coque semiconductrice 13, et le premier élément conducteur 7 est disposé sur une face opposée de la première couche d'isolation électrique 4. La connexion électrique entre le premier élément conducteur 7 et le noyau semiconducteur 11 est réalisée par l'intermédiaire des ouvertures traversantes 15, traversant la première couche d'isolation électrique 4. Pour améliorer la clarté des figures, le premier élément conducteur 7, et le deuxième élément conducteur 9 ne sont pas représentés systématiquement. Il est cependant bien compris que d'autres modes de réalisation peuvent être mis en oeuvre pour permettre la connexion électrique entre le premier élément conducteur 7 et le noyau semiconducteur 11, et entre le deuxième élément conducteur 9 et la coque semiconductrice 13.

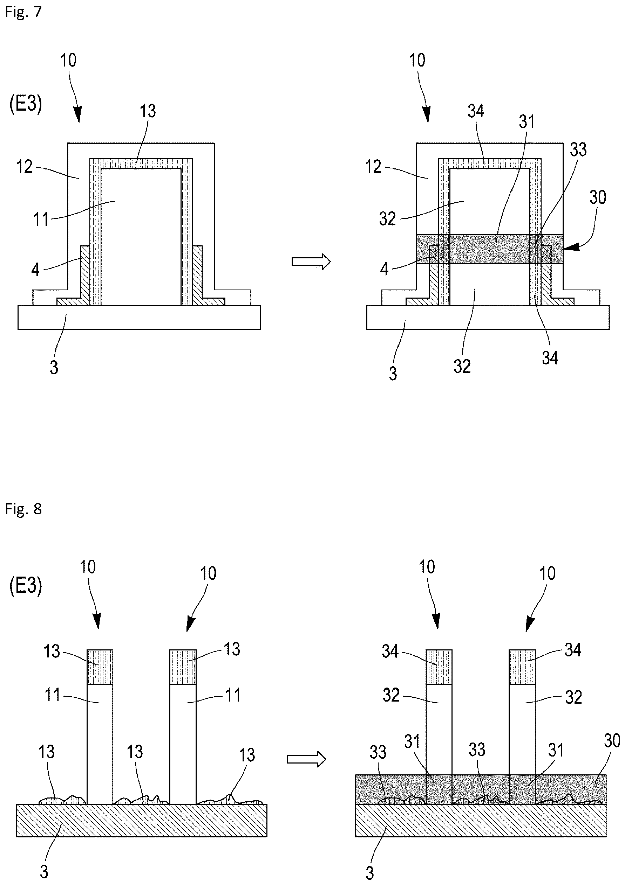

Enfin, et comme illustré sur la figure 7, le dispositif optoélectronique peut comprendre une électrode transparente conductrice 12 configurée pour assurer une connexion électrique entre le deuxième élément conducteur 9 et la coque semiconductrice 13. Il est cependant bien compris qu'une telle électrode transparente conductrice 12 peut être adapté à n'importe quel autre mode de réalisation, comme ceux représentés sur les figures 1 à 7.

Les dispositions précédemment décrites permettent de proposer un dispositif optoélectronique 1 à diodes électroluminescentes 10 adapté pour effectuer la conversion d'un signal électrique en un rayonnement lumineux.

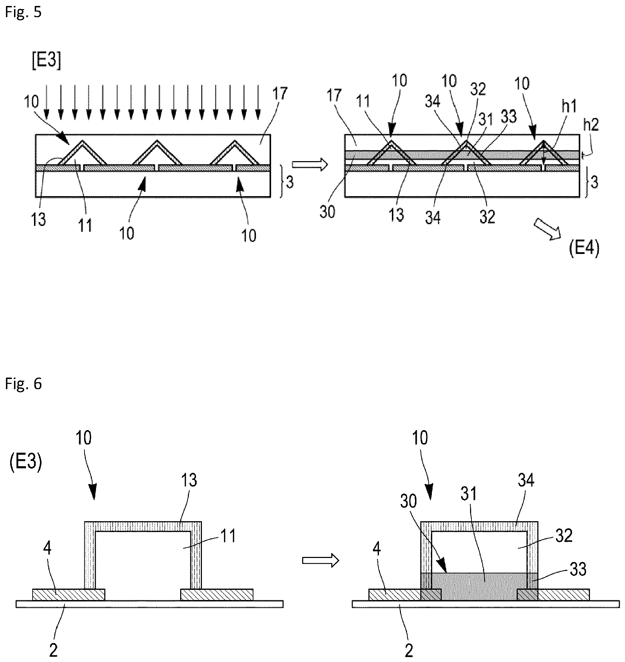

Comme indiqué précédemment, la diode électroluminescente 10 présente une forme tridimensionnelle, ladite forme tridimensionnelle pouvant prendre la forme d'un microfil, d'un nanofil, d'un cône, d'un tronc de cône, d'une pyramide, ou d'une pyramide tronquée. De manière générale, ladite forme tridimensionnelle de la diode électroluminescente 10 dépend de la forme du noyau semiconducteur 11 et de la forme de la coque semiconductrice 13. Ainsi, si au moins un élément semiconducteur choisi dans le groupe comprenant le noyau semiconducteur 11 et la coque semiconductrice 13 présente une forme filaire, conique, tronconique, pyramidale ou de pyramide tronquée la forme de la diode électroluminescente 10 sera semblable. Par exemple, et en référence aux figures 1 à 5, le noyau semiconducteur 11 peut présenter une forme pyramidale ou conique, et peut être disposé sur la face de support 5, de manière à être en contact avec le support 3, 8 par la partie proximale p1. Alternativement et comme représenté sur les figures 6 à 8, le noyau semiconducteur 11 peut présenter une forme de nanofil. Sur les modes de réalisation des figures 1 à 7, la coque semiconductrice 13 recouvre intégralement le noyau semiconducteur 11 lorsqu'il est en contact avec la face de support 5 du support 3, 8, de sorte que la coque semiconductrice 13 épouse la forme pyramidale, conique, ou filaire du noyau semiconducteur 11. Selon le mode de réalisation de la figure 8 en revanche, la coque semiconductrice 13 recouvre d'une part partiellement le noyau semiconducteur 11 au niveau de la partie distale d1, et d'autre part des flancs du noyau semiconducteur 11, sous la forme de dépôts résiduels, disjoints ou non de la partie distale d1.

Selon un mode de réalisation, le noyau semiconducteur 11 comprend du nitrure de gallium GaN dopé N, et la coque semiconductrice 13 comprend du nitrure de gallium GaN dopé P. Alternativement, au moins un élément semiconducteur choisi parmi le noyau semiconducteur 11 et la coque semiconductrice 13 comprend de l'arséniure de gallium GaAs dopé ou non, ou de l'arséniure de gallium-indium GalnAs dopé ou non, ou un autre matériau III-V. Par « dopage P » ou « dopé P », on entend qu'un matériau semiconducteur comprend une forte quantité d'atomes accepteurs d'électrons permettant d'obtenir une plus faible densité d'électrons libres, donc un excès de trous, lesdits trous étant positivement chargés. Par exemple un atome accepteur d'électron peut être le magnésium. Par « dopage N » ou « dopé N », on entend qu'un matériau semiconducteur comprend une forte quantité d'atomes donneurs d'électrons afin d'obtenir une plus forte densité d'électrons libres, qui sont négativement chargés. Par exemple un atome donneur d'électrons peut être le silicium ou le germanium.

La diode électroluminescente 10 comprend en outre, une portion implantée 30 s'étendant sur une hauteur implantée h2 comptée suivant la première direction X, ladite hauteur implantée h2 étant strictement inférieure à la hauteur h1 de la diode. Par exemple, la hauteur implantée h2, comptée le long de la première direction X, est inférieure à 500 nm.

La portion implantée 30 est disposée entre la partie distale d1 et la partie proximale p1, et est disjointe de la partie distale d1. Selon les variantes représentées sur les figures 1 à 4, 6, et 8, la portion implantée 30 est positionnée, suivant la première direction X, de sorte à incorporer la partie proximale p1 de la diode électroluminescente 10. Alternativement, et comme représenté sur les figures 5 et 7, la portion implantée 30 est disjointe de la partie proximale p1. Par portion, ou élément « passivé » ou « neutralisé », on entend que ladite portion ou ledit élément voit la valeur absolue de sa conductivité diminuer. Par exemple, ladite portion ou ledit élément peut devenir isolant lorsqu'il est passivé. Par conséquent, il est avantageux que la portion implantée 30 soit disjointe de la partie distale d1 de sorte à permettre la conversion d'un signal électrique en un rayonnement lumineux au niveau de ladite partie distale d1.

La portion implantée 30 peut délimiter au sein du noyau semiconducteur 11 au moins une première portion implantée 31 disjointe de la partie distale d1 de la diode électroluminescente 10. Par conséquent, le noyau semiconducteur 11 comprend également au moins une première portion non-implantée 32 délimitée au moins partiellement par ladite au moins une première portion implantée 31. Ladite au moins une première portion implantée 31 présente une concentration ionique strictement différente d'une concentration ionique de ladite au moins une première portion non-implantée 32. Par « concentration ionique », on entend la concentration des ions implantés.

La portion implantée 30 délimite en outre au sein de la coque semiconductrice 13 au moins une portion passivée 33 disjointe de la partie distale d1 de la diode électroluminescente 10. Par conséquent, la coque semiconductrice 13 comprend également au moins une portion active 34 délimitée au moins partiellement par ladite au moins une portion passivée 33. Ladite au moins une portion passivée 33 présente une conductivité strictement inférieure à une conductivité de ladite au moins une portion active 34.

De manière générale, la portion implantée 30 est une zone de la diode électroluminescente 10 dans laquelle des ions sont implantés, où chaque ion implanté forme un complexe avec un élément dopant, le dopage selon le premier type de conductivité du noyau semiconducteur 11 étant alors neutralisé au niveau de la première portion implantée 31, et/ou le dopage selon le deuxième type de conductivité de la coque semiconductrice 13 étant neutralisé au niveau de la portion passivée 33. Il est également possible que les ions implantés dans la portion implantée 30 forment des niveaux profonds. Cela a pour conséquence de limiter ou de supprimer la mobilité des porteurs de charge positive ou négative, sans que ces niveaux profonds ne servent de centre de recombinaison non radiatifs. Par exemple, l'implantation ionique comprend l'implantation d'au moins un ion choisi parmi les ions argon Ar, les ions hélium He, les ions néon Ne, les ions oxygène O, les ions germanium Ge, les ions arsenic As, les ions phosphore P, les ions bore B, les ions magnésium Mg, les ions silicium Si, les ions aluminium Al, les ions fluor F, les ions azote N, et les ions hydrogène H. Ainsi, il est possible d'implanter des ions dans des niveaux profonds, de manière à neutraliser les porteurs de charges libre du noyau semiconducteur 11 et/ou de la coque semiconductrice 13 au niveau de la première portion implantée 31 et/ou de la portion passivée 33.

Selon un mode de réalisation dans lequel le noyau semiconducteur 11 est constitué principalement de nitrure de gallium dopé par le magnésium, les ions hydrogène H⁺ implantés forment avec le dopant magnésium, un complexe magnésium hydrogène Mg-H. Ainsi, l'implantation ionique permet de neutraliser le dopage P en magnésium, et permet ainsi de passiver la première portion implantée 31, afin de diminuer sa conductivité. Par « composé constitué principalement d'un matériau », on entend qu'un composé comprend une proportion supérieure ou égale à 95% dudit matériau, cette proportion étant préférentiellement supérieure à 99%.

Les dispositions précédemment décrites permettent de proposer une diode électroluminescente 10 comprenant une portion implantée 30 ayant une conductivité diminuée localement. La forme tridimensionnelle de la diode électroluminescente 10 permet en outre de définir plus simplement une portion implantée 30 dans laquelle la conductivité est diminuée.

De manière plus générique, l'invention peut également comprendre un organe optoélectronique comprenant un support 3, 8 s'étendant selon un plan, et au moins une diode électroluminescente 10 telle que décrite précédemment dans laquelle la portion implantée 30 est sensiblement parallèle au plan du support 3, 8. De manière avantageuse, l'organe optoélectronique peut comprendre une couche de remplissage intercalaire (par exemple la couche de planarisation 17) disposée entre deux diodes électroluminescentes 10. Ladite couche de remplissage intercalaire peut présenter un profil de réaction à l'implantation ionique approprié, régissant la profondeur d'implantation en fonction de l'énergie d'implantation, typiquement similaire à celui des matériaux composant la diode électroluminescente 10, et ainsi comprendre une portion intercalaire implantée parallèlement au plan du support 3, 8 et dans le prolongement de la portion implanté 30 des diodes électroluminescentes 10. De cette manière, il est possible de déterminer et de contrôler la profondeur d'implantation ionique en fonction de l'énergie d'implantation. Ainsi, il est possible de maîtriser l'implantation ionique lorsqu'elle est mise en oeuvre sur une portion transversale continue de l'organe optoélectronique. Les dispositions précédemment décrites s'appliquent également au dispositif optoélectronique 1 objet de l'invention.

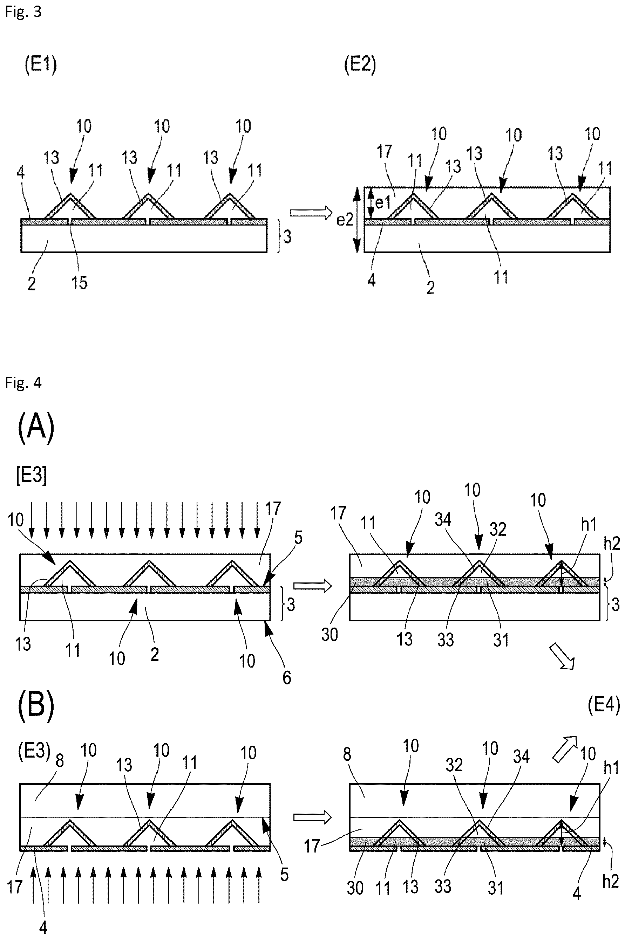

Les figures 3 à 8 illustrent les étapes d'un procédé de fabrication objet de l'invention, permettant de fabriquer un dispositif optoélectronique 1 du type d'un de ceux décrits précédemment.

Le procédé de fabrication comprend tout d'abord une étape de fourniture E1 d'un dispositif optoélectronique initial comprenant un support 3, 8 présentant une face de support 5 et au moins une diode électroluminescente 10 coopérant directement ou indirectement avec ladite face de support 5. Ladite au moins une diode électroluminescente 10 présente une forme tridimensionnelle, et comprend une hauteur h1 s'étendant selon une première direction X entre une partie proximale p1 et une partie distale d1 opposée à ladite partie proximale p1 le long de ladite première direction X. Ladite diode électroluminescente 10 comprend un noyau semiconducteur 11 dopé selon un premier type de conductivité, et une coque semiconductrice 13 dopée selon un deuxième type de conductivité opposé au premier type de conductivité, ladite coque semiconductrice 13 recouvrant au moins partiellement ledit noyau semiconducteur 11. Selon une première variante, ladite au moins une diode électroluminescente 10 est disposée sur ladite face de support 5 du support 3, 8 de sorte que la partie proximale p1 de l'au moins une diode électroluminescente 10 soit tournée vers la face de support 5 du support 3, 8, et de sorte que la première direction X s'étende transversalement à ladite face de support 5. Il peut cependant être prévu que la diode électroluminescente 10 soit tournée dans l'autre sens par rapport au support 3, 8. Selon un mode de réalisation, le dispositif optoélectronique initial fourni lors de l'étape de fourniture E1 comprend un premier élément conducteur 7 connecté électriquement au noyau semiconducteur 11 de la diode électroluminescente 10, et un deuxième élément conducteur 9 connecté électriquement à la coque semiconductrice 13 de la diode électroluminescente 10.

Selon un mode de réalisation, l'au moins une diode électroluminescente 10 présentant une forme tridimensionnelle peut être fabriquée conformément à l'un des modes de réalisation décrits dans les documents FR3031242A1, ou FR3098013A1. Par ailleurs, et comme illustré précédemment, le premier élément conducteur 7 peut être connecté électriquement au noyau semiconducteur 11 au niveau de la partie proximale p1, par exemple par l'intermédiaire d'ouvertures traversantes 15 ménagées à travers le support 3, 8.

La figure 3 illustre une étape de planarisation E2 dans laquelle une couche de planarisation 17 est déposée au niveau de la face de support 5 du support 3, 8 jusqu'à ce qu'une épaisseur e1 de la couche de planarisation 17, vue selon la première direction X et comptée à partir de la face de support 5, soit au moins égale à la hauteur h1 de l'au moins une diode électroluminescente 10. Par exemple, la couche de planarisation 17 comprend un matériau isolant, par exemple le dioxyde de silicium SiO₂. De manière avantageuse, l'étape de planarisation E2 est mise en oeuvre de manière à recouvrir l'au moins une diode électroluminescente 10.

Une telle étape de planarisation E2 peut être mise en oeuvre avant une étape de passivation E3 du procédé de fabrication qui sera décrite ci-après. Avantageusement, l'étape de planarisation E2 permet d'uniformiser une épaisseur e2 du dispositif optoélectronique 1 le long de la première direction X, ce qui permet de mieux contrôler des profondeurs d'implantation d'ions notamment lors de l'étape de passivation E3. Cela permet en outre d'obtenir une passivation différentielle entre l'élément semiconducteur dopé N, et l'élément semiconducteur dopé P.

Les figures 4 à 8 illustrent ladite étape de passivation E3 dans laquelle l'au moins une diode électroluminescente 10 est passivée sur une portion implantée 30 s'étendant sur une hauteur implantée h2 comptée suivant la première direction X, ladite hauteur implantée h2 étant strictement inférieure à la hauteur h1 de la diode électroluminescente 10. Par exemple, l'étape de passivation E3 peut être mise en oeuvre sur une hauteur implantée h2, comptée le long de la première direction X, inférieure à 500 nm. Par portion, ou élément « passivé » ou « neutralisé », on entend que ladite portion ou ledit élément voit la valeur absolue de sa conductivité diminuer. Par exemple, ladite portion ou ledit élément peut devenir isolant après avoir subi l'étape de passivation E3.

La portion implantée 30 est disposée entre la partie distale d1 et la partie proximale p1, et étant disjointe de la partie distale d1. Selon les variantes représentées sur les figures 4, 6, et 8, l'étape de passivation E3 est mise en oeuvre au niveau de la partie proximale p1, de manière à ce que la partie proximale p1 soit incluse dans la portion implantée 30. Ainsi, et de manière avantageuse, il est possible de neutraliser la conductivité au niveau de la partie proximale p1. Par exemple dans le cas d'une diode électroluminescente 10 tridimensionnelle en forme de microfil, de nanofil, de cône, de tronc de cône ou de pyramide, il est possible de neutraliser la partie proximale p1, afin d'émettre de la lumière qu'au niveau de la partie distale d1. Ainsi, tout défaut cristallin parasite, comme un dépôt résiduel de la coque semiconductrice 13, possiblement présent au niveau de la partie proximale p1, peut être neutralisé. Il est alors possible d'améliorer l'efficacité d'émission et l'extraction de lumière de la diode électroluminescente 10 tridimensionnelle.

De manière générale, l'étape de passivation E3 est mise en oeuvre de sorte que la portion implantée 30 délimite au sein du noyau semiconducteur 11 au moins une première portion implantée 31 disjointe de la partie distale d1 de la diode électroluminescente 10. Le noyau semiconducteur 11 comprend alors au moins une première portion non-implantée 32 délimitée au moins partiellement par ladite au moins une première portion implantée 31, ladite au moins une première portion implantée 31 ayant une concentration ionique strictement différente d'une concentration ionique de ladite au moins une première portion non-implantée 32.

Par ailleurs, l'étape de passivation E3 est mise en oeuvre de sorte que la portion implantée 30 délimite en outre au sein de la coque semiconductrice 13 au moins une portion passivée 33 disjointe de la partie distale d1 de la diode électroluminescente 10. La coque semiconductrice 13 comprend alors au moins une portion active 34 délimitée au moins partiellement par ladite au moins une portion passivée 33, ladite au moins une portion passivée 33 ayant une conductivité strictement inférieure à une conductivité de ladite au moins une portion active 34.

Dans le cas où le premier élément conducteur 7 est connecté électriquement au noyau semiconducteur 11 dopé N, au niveau de la partie proximale p1, par exemple par l'intermédiaire d'ouvertures traversantes 15 ménagées à travers le support 3, 8, et dans le cas où l'étape de passivation E3 a un faible impact sur la conductivité du noyau semiconducteur 11, il est possible garantir une bonne connexion électrique entre le noyau semiconducteur 11 et le premier élément conducteur 7, tout en passivant la portion passivée 33.

Selon les modes de réalisation illustrés aux figures 5 et 7, l'étape de passivation E3 est mise en oeuvre de manière à ce que la portion implantée 30 soit disjointe de la partie proximale p1. Ainsi, il est possible de proposer une diode électroluminescente 10 ayant au moins deux premières portions actives 32 et au moins deux portions actives 34 séparées par la portion implantée 30. Chaque première portion non-implantée 32 adjacente à une portion active 34 sera alors apte à émettre de la lumière, par conversion d'énergie électrique en rayonnement lumineux.

Selon les deux variantes non limitatives représentées sur les figures 4, et 5, l'étape de passivation E3 est mise en oeuvre par une implantation ionique, d'une manière permettant de neutraliser le dopage selon le premier type de conductivité du noyau semiconducteur 11 au niveau de la première portion implantée 31, et/ou d'une manière permettant de neutraliser le dopage selon le deuxième type de conductivité de la coque semiconductrice 13 au niveau de la portion passivée 33. Ainsi, et de manière avantageuse, il est possible de modifier la conductivité de la première portion implantée 31 et de la portion passivée 33 par une implantation ionique. Par exemple, l'implantation ionique est réalisée par l'implantation d'ions à travers la diode électroluminescente 10, et/ou à travers le dispositif optoélectronique 1. Avantageusement, l'étape de passivation E3 par implantation ionique d'une diode électroluminescente 10 tridimensionnelle permet d'implanter simultanément des ions dans le noyau semiconducteur 11 et dans la coque semiconductrice 13. Ainsi, l'étape de passivation E3 est mise en oeuvre par implantation ionique en volume. Il est ainsi possible d'implanter simultanément la coque semiconductrice 13 et le noyau semiconducteur 11, en ne passivant électriquement uniquement l'élément semiconducteur (parmi la coque semiconductrice 13 et le noyau semiconducteur 11) qui a un type de conductivité de type P. Cela permet d'effectuer une désactivation différentielle des porteurs de charge entre la partie semiconductrice dopée P, et la partie semiconductrice dopée N.

Selon les variantes illustrées sur les figures 4 A et 5, l'étape de passivation E3 est mise en oeuvre par implantation ionique à partir de la partie distale d1 vers la partie proximale p1.

Alternativement, et comme illustré sur la figure 4 B, l'implantation ionique mise en oeuvre lors de l'étape de passivation E3 est réalisée à partir de la partie proximale p1 vers la partie distale d1. Selon un mode de réalisation non représenté, il peut également être prévu que l'implantation ionique soit mise en oeuvre à partir d'une face arrière 6 du support 3, 8, ladite face arrière 6 du support 3, 8 étant opposée à la face de support 5 du support 3, 8.

De manière générale, l'étape de passivation E3 est mise en oeuvre sur une hauteur implantée h2, comptée le long de la première direction X, inférieure à 500 nm. Ainsi, il est possible de former la portion implantée 30, par exemple par implantation ionique, en utilisant des gammes d'énergie d'implantation habituellement utilisées dans les procédés microélectroniques. Une énergie d'implantation peut notamment être comprise entre 1 keV, et 500 keV. Par exemple, ladite énergie d'implantation peut être définie en fonction de la masse de l'ion implanté, et en fonction de l'épaisseur de matériau à traverser.

Dans le cas de la mise en oeuvre de l'étape de passivation E3 par implantation ionique, il peut être prévu d'utiliser au moins un ion choisi parmi les ions argon Ar, les ions hélium He, les ions néon Ne, les ions oxygène O, les ions germanium Ge, les ions arsenic As, les ions phosphore P, les ions bore B, les ions magnésium Mg, les ions silicium Si, les ions aluminium Al, les ions fluor F, les ions azote N, et les ions hydrogène H. Ainsi, il est possible d'implanter des ions dans des niveaux profonds, de manière à neutraliser les porteurs de charges libre du noyau semiconducteur 11 et/ou de la coque semiconductrice 13 au niveau de la première portion implantée 31 et de la portion passivée 33. De manière synergique, la neutralisation des porteurs de charge libre lors de l'étape de passivation E3 permet de rendre le noyau semiconducteur 11 et la coque semiconductrice 13 moins conducteurs sans créer de centres de recombinaison des porteurs non radiatifs, ce qui serait dommageable dans le cas de dispositifs optoélectroniques 1. Par exemple, une dose d'ions implantée est comprise entre 10¹¹ at/cm², et 10¹⁴ at/cm². Par exemple, ladite dose d'ions implantée peut être définie en fonction de la masse de l'ion implanté, et en fonction de l'épaisseur de matériau à traverser.

De manière avantageuse, l'étape de passivation E3 peut être mise en oeuvre par une implantation d'ions hydrogène. En effet, l'utilisation d'une implantation hydrogène, c'est-à-dire une implantation d'ions H⁺, permet de passiver plus efficacement un matériau dopé P qu'un matériau dopé N, en utilisant des faibles doses d'implantation ionique. De cette manière, il est possible de passiver sélectivement ou de manière différentielle, un matériau dopé P par rapport à un matériau dopé N en une seule étape de procédé.

Enfin, le procédé de fabrication peut comprendre une étape de recuit E4 dans laquelle le dispositif optoélectronique 1 est chauffé à une température de recuit, ladite température de recuit étant inférieure à 500°C. De manière avantageuse, l'étape de recuit E4 permet de régénérer l'élément semiconducteur dopé N, comme par exemple le noyau semiconducteur 11, afin de limiter l'impact de l'étape de passivation E3 sur cet élément semiconducteur. Cela permet en outre d'obtenir une passivation différentielle entre l'élément semiconducteur dopé N, et l'élément semiconducteur dopé P.

Les dispositions précédemment décrites permettent de fabriquer un dispositif optoélectronique 1 comprenant au moins une diode électroluminescente 10 comprenant une portion implantée 30 ayant une conductivité diminuée localement. La forme tridimensionnelle de la diode électroluminescente 10 permet délimiter une portion implantée 30 dans laquelle la conductivité est diminuée, lors de l'étape de passivation E3.

## Revendications

1. Diode électroluminescente (10) pour dispositif optoélectronique (1), la diode électroluminescente (10) présentant une forme tridimensionnelle et comprenant une hauteur (h1) s'étendant selon une première direction (X) entre une partie proximale (p1) et une partie distale (d1) opposée à ladite partie proximale (p1) le long de ladite première direction (X), ladite diode électroluminescente (10) comprenant :
- un noyau semiconducteur (11) dopé selon un premier type de conductivité, la partie proximale (p1) correspondant à une base de croissance dudit noyau semiconducteur (11) ;
- une coque semiconductrice (13) dopée selon un deuxième type de conductivité opposé au premier type de conductivité, ladite coque semiconductrice (13) recouvrant au moins partiellement ledit noyau semiconducteur (11) ;
la diode électroluminescente (10) comprenant une portion implantée (30) s'étendant sur une hauteur implantée (h2) comptée suivant la première direction (X), ladite hauteur implantée (h2) étant strictement inférieure à la hauteur (h1) de la diode, ladite portion implantée (30) étant disposée entre la partie distale (d1) et la partie proximale (p1) et étant disjointe de la partie distale (d1), de sorte que la portion implantée (30) délimite au sein de la coque semiconductrice (13) au moins une portion passivée (33) disjointe de la partie distale (d1) de la diode électroluminescente (10), la coque semiconductrice (13) comprenant au moins une portion active (34) délimitée au moins partiellement par ladite au moins une portion passivée (33), ladite au moins une portion passivée (33) ayant une conductivité strictement inférieure à une conductivité de ladite au moins une portion active (34).

2. Diode électroluminescente (10) selon la revendication 1, dans laquelle la portion implantée (30) délimite au sein du noyau semiconducteur (11) au moins une première portion implantée (31) disjointe de la partie distale (d1) de la diode électroluminescente (10), le noyau semiconducteur (11) comprenant au moins une première portion non-implantée (32) délimitée au moins partiellement par ladite au moins une première portion implantée (31), ladite au moins une première portion implantée (31) ayant une concentration ionique strictement différente d'une concentration ionique de ladite au moins une première portion non-implantée (32).

3. Diode électroluminescente (10) selon l'une quelconque des revendications 1 ou 2, dans laquelle le noyau semiconducteur (11) comprend du nitrure de gallium (GaN) dopé N, et dans lequel la coque semiconductrice (13) comprend du nitrure de gallium (GaN) dopé P.

4. Diode électroluminescente (10) selon l'une quelconque des revendications 1 à 3, dans laquelle la portion implantée (30) est une zone de la diode électroluminescente (10) s'étendant transversalement à la première direction (X), et dans laquelle des ions sont implantés où chaque ion implanté forme :
- un complexe avec un élément dopant, le dopage selon le deuxième type de conductivité de la coque semiconductrice (13) étant neutralisé au niveau de la portion passivée (33) ; ou
- des niveaux profonds ce qui limite ou supprime la mobilité des porteurs de charge positive ou négative, sans que ces niveaux profonds ne servent de centre de recombinaison non radiatifs.

5. Diode électroluminescente (10) selon la revendication 4, dans laquelle les ions implantés sont des ions hydrogène.

6. Diode électroluminescente (10) selon l'une quelconque des revendications 1 à 5, dans laquelle au moins un élément semiconducteur choisi dans le groupe comprenant le noyau semiconducteur (11) et la coque semiconductrice (13) présente une forme filaire, conique, tronconique, de pyramide, ou de pyramide tronquée.

7. Diode électroluminescente (10) selon l'une quelconque des revendications 1 à 6, dans laquelle la portion implantée (30) est positionnée, suivant la première direction (X), de sorte à incorporer la partie proximale (p1) de la diode électroluminescente (10).

8. Organe optoélectronique comprenant un support (3, 8) s'étendant selon un plan, et au moins une diode électroluminescente (10) selon l'une quelconque des revendications 1 à 7 ; la portion implantée (30) de ladite au moins une diode électroluminescente étant sensiblement parallèle au plan du support (3, 8).

9. Dispositif optoélectronique (1) comprenant :
- un support (3, 8) présentant une face de support (5) ;
- au moins une diode électroluminescente (10) selon l'une quelconque des revendications 1 à 9, coopérant directement ou indirectement avec ladite face de support (5) ;
- un premier élément conducteur (7) connecté électriquement au noyau semiconducteur (11) de la diode électroluminescente (10), et
- un deuxième élément conducteur (9) connecté électriquement à la coque semiconductrice (13) de la diode électroluminescente (10).

10. Procédé de fabrication d'un dispositif optoélectronique (1) comprenant les étapes suivantes :
- une étape de fourniture (E1) d'un dispositif optoélectronique initial comprenant :
• un support (3, 8) présentant une face de support (5) ; et
• au moins une diode électroluminescente (10) coopérant directement ou indirectement avec ladite face de support (5), ladite au moins une diode électroluminescente (10) présentant une forme tridimensionnelle, et comprenant une hauteur (h1) s'étendant selon une première direction (X) entre une partie proximale (p1) et une partie distale (d1) opposée à ladite partie proximale (p1) le long de ladite première direction (X), ladite diode électroluminescente (10) comprenant un noyau semiconducteur (11) dopé selon un premier type de conductivité, la partie proximale (p1) correspondant à une base de croissance dudit noyau semiconducteur (11), et comprenant une coque semiconductrice (13) dopée selon un deuxième type de conductivité opposé au premier type de conductivité, ladite coque semiconductrice (13) recouvrant au moins partiellement ledit noyau semiconducteur (11) ;
- une étape de passivation (E3) de l'au moins une diode électroluminescente (10) pour former le dispositif optoélectronique (1), dans laquelle l'au moins une diode électroluminescente (10) est passivée sur une portion implantée (30) s'étendant sur une hauteur implantée (h2) comptée suivant la première direction (X), ladite hauteur implantée (h2) étant strictement inférieure à la hauteur (h1) de la diode électroluminescente (10), ladite portion implantée (30) étant disposée entre la partie distale (d1) et la partie proximale (p1), et étant disjointe de la partie distale (d1), de sorte que
la portion implantée (30) délimite au sein de la coque semiconductrice (13) au moins une portion passivée (33) disjointe de la partie distale (d1) de la diode électroluminescente (10), la coque semiconductrice (13) comprenant au moins une portion active (34) délimitée au moins partiellement par ladite au moins une portion passivée (33), ladite au moins une portion passivée (33) ayant une conductivité strictement inférieure à une conductivité de ladite au moins une portion active (34).

11. Procédé de fabrication selon la revendication 10, dans lequel lors de l'étape de passivation (E3), l'au moins une diode électroluminescente (10) est passivée de sorte que la portion implantée (30) délimite également au sein du noyau semiconducteur (11) au moins une première portion implantée (31) disjointe de la partie distale (d1) de la diode électroluminescente (10), le noyau semiconducteur (11) comprenant au moins une première portion non-implantée (32) délimitée au moins partiellement par ladite au moins une première portion implantée (31), ladite au moins une première portion implantée (31) ayant une concentration ionique strictement différente d'une concentration ionique de ladite au moins une première portion non-implantée (32).

12. Procédé de fabrication selon l'une des revendications 10 ou 12, dans lequel l'étape de passivation (E3) est mise en oeuvre par une implantation d'ions hydrogène.

13. Procédé de fabrication selon la revendication 12, dans lequel l'implantation ionique est mise en oeuvre à partir d'une face arrière (6) du support (3, 8), ladite face arrière (6) du support (3, 8) étant opposée à la face de support (5) du support (3, 8).

14. Procédé de fabrication selon la revendication 12 dans lequel l'implantation ionique est mise en oeuvre à partir de la face de support (5).

15. Procédé de fabrication selon l'une quelconque des revendications 10 à 14, dans lequel l'étape de passivation (E3) est mise en oeuvre au niveau de la partie proximale (p1), de manière à ce que la partie proximale (p1) soit incluse dans la portion implantée (30).

16. Procédé de fabrication selon l'une quelconque des revendications 10 à 15, comprenant en outre une étape de planarisation (E2) dans laquelle une couche de planarisation (17) est déposée au niveau de la face de support (5) du support (3, 8) jusqu'à ce qu'une épaisseur (e1) de la couche de planarisation (17), vue selon la première direction (X) et comptée à partir de la face de support (5), soit au moins égale à la hauteur (h1) de l'au moins une diode électroluminescente (10).

17. Procédé de fabrication selon la revendication 16, dans lequel l'étape de planarisation (E2) est mise en oeuvre avant l'étape de passivation (E3).

18. Procédé de fabrication selon l'une quelconque des revendications 10 à 17, comprenant en outre une étape de recuit (E4) dans laquelle le dispositif optoélectronique (1) est chauffé à une température de recuit, ladite température de recuit étant inférieure à 500°C.
